# EUROPEAN PATENT SPECIFICATION

(11) **EP 0 457 595 B1**
(45) Date of publication and mention of the grant of the patent: **23.08.1995**
(21) Application number: 91304422.8
(22) Date of filing: 16.05.1991
(51) Int. Cl.: H04L 25/02, H04B 3/00

(54) **Communication apparatus for transmitting and receiving communication signals through common transmission line**
Übertragungsgerät zum Senden und Empfangen von Nachrichtensignalen über eine gemeinsame Übertragungsstrecke
Appareil de communication pour transmettre et recevoir des signaux de communication sur une ligne commune de transmission

(30) Priority: 17.05.1990 JP 127870/90; 08.08.1990 JP 211040/90; 22.04.1991 JP 90643/91
(43) Date of publication of application: 21.11.1991
(73) Proprietor: NIPPONDENSO CO., LTD., Kariya-city Aichi-pref., 448 (JP)
(72) Inventor: Yamamoto, Kiyoshi, Toyohashi-city, Aichi-pref. (JP); Suzuki, Satoshi, Nagoya-city, Aichi-pref. (JP); Sato, Yoshihisa, Nukata-gun, Aichi-pref. (JP); Kobayashi, Masayuki, Anjo-city, Aichi-pref. (JP)
(74) Representative: Dempster, Benjamin John Naftel

(56) References cited:
- EP-A- 0 323 525
- WO-A-88/05979
- DD-A- 125 310
- DE-A- 3 941 531

## Description

The present invention relates to communication apparatus, more particularly to communication apparatus suitable for use in a multiplex transmission system in which a plurality of control circuits (hereinafter referred to as ECU) are capable of transmitting and receiving communication signals through a common transmission line.

A communication signal to be transmitted among ECUs has been expressed by combination of square wave signals and information transmitted by comparing a demodulated signal received by an ECU with a predetermined threshold value.

However, such a threshold value is affected by GND voltage differences between ECUs and fluctuations in the power supply voltage, thereby resulting in errors generated during modulating and demodulating operations so that accurate transmission of communication signal is prevented.

Moreover, since such square wave signals rise and fall sharply, communication signals combining such square wave signals contain a considerable degree of harmonics.

Therefore, for baseband transmission along the common transmission line, since the communication signal is a square wave, harmonics of baseband are radiated and superposed on the radio frequency band, adversely affecting other devices, for example, by interfering with the reception of radio programs. It is therefore important to suppress the radiation of harmonics noise.

One possibility is not to transmit the square wave as generated by a processing circuit but to transmit after modulation to a trapezoidal wave, the trapezoidal wave then being received by each ECU after demodulation to the square wave with reference to a constant threshold value preset in the receiving circuit. Hence, spectrum power of the harmonics is reduced by utilizing the trapezoidal wave for the communication signal and thereby radiation of noise is reduced to a very small amount.

However, by comparison with the square wave transmission method such trapezoidal wave transmission generates errors during modulation or demodulation due *inter alia* to fluctuation of threshold voltage and communication signal voltage. Moreover, although this method is effective in reducing noise radiation at lower transmission rates (typically 10 kbps), at intermediate transmission rates of say 100 kbps, the baseband reaches 50 kHz in maximum when the transmission rate is, for example, 100 kbps. This baseband frequency is very close to the AM radio frequency band (about 500 to 700 kHz) and the radiation of harmonics noise still has adverse effect.

WO88/05979 discloses a device for the remote transmission of video signals. Video and audio signals on different lines are combined in an adder, which has two outputs. One output leads to a first current generator which feeds a first transmission line and the other output leads through an inverter to a second current generator which feeds a second transmission line. A receiving circuit is also provided for signals on the two transmission lines. The receiving circuit includes a differential amplifier and a de-modulator to check the signals.

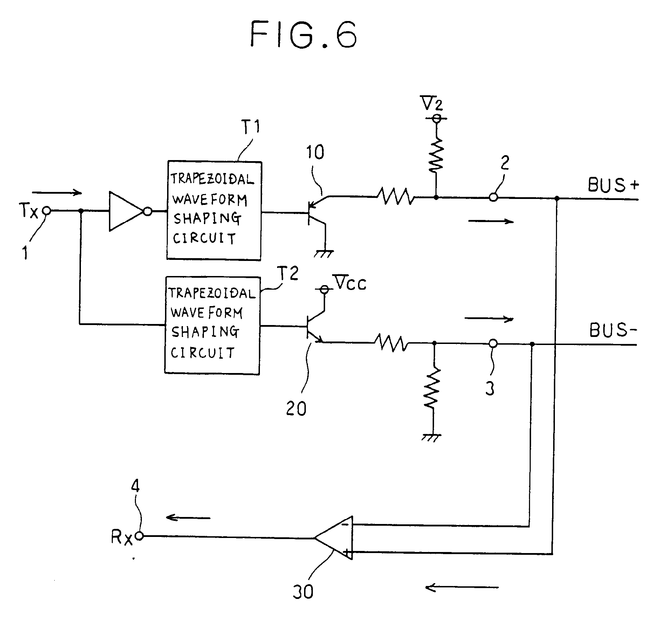

In the circuit designed by the inventors of the present invention and shown in Fig. 6 a square wave signal received from an input terminal 1 from a transmitter Tx is branched to two routes, each of these square wave signals is respectively processed by trapezoidal wave shaping circuits T1, T2. One signal waveform is inverted and the pair of signals are transmitted to different transmission lines of the balanced two-wire system through output terminals 2, 3. These two signal waveforms are compared in amplitude by a comparator 30 in the receiving side and then demodulated into the square wave signals so as to suppress modulation and demodulation errors as much as possible.

The circuit shown in Fig. 6 is certainly capable of reducing modulation and demodulation errors but also gives rise to adverse effects due to radiation of harmonics noise when used for communication at intermediate transmission rates of about 100 kbps.

Further investigation of the circuit explained above, has shown that since different trapezoidal wave shaping circuits T1, T2 provide outputs after the shaping of the one trapezoidal wave signal and the other signal to form an inverse waveform signal of the one trapezoidal wave signal in the preceding stage of the transistors 10, 20 for transmission line drive, the output waveform in the side of inverse output cannot be shaped to extremely accurate inverse polarity waveform of the one output waveform due to fluctuations by several tens of percent in the resistance and capacitance values within ICs when considering employment of IC structure of circuits, particularly adjustment-free circuit design, the influence of phase shift and time delay of waveform transition increases to a value which cannot be neglected as the transmission rate increases and thereby harmonics noise may result.

It has also been found that the harmonics noise is cancelled and influence of noise radiation may be suppressed by use of a balanced two-wire transmission system and transmitting the one output waveform as the extremely accurate inverse polarity output, namely by applying the currents which are same in the amplitude but are of opposite polarity.

Further, when one output waveform is transmitted as the extremely accurate inverse (i.e has the opposite polarity) of the other output in such balanced two-wire transmission system, the radiation of harmonics noise can be suppressed even when the square wave signal is not modulated to the trapezoidal wave signal.

One object of the present invention is to minimize modulation and demodulation errors without influence of fluctuation of GND potential difference between ECUs and power supply voltage difference and also favourably suppress influence of harmonics noise radiation even for intermediate and moreover high transmission rate signal.

In order to achieve such object, we propose in accordance with one aspect of the present invention, communication apparatus in which a first control circuit comprising at least a transmitting circuit and a second control circuit comprising at least a receiving circuit are connected by common transmission line means, wherein;
the common transmission line means comprising a first and a second transmission line;
the transmitting circuit comprising first transmitting means for converting information to be communicated into a communication signal for transmission along the first transmission line and second transmitting means for generating an inverted polarity communication signal for transmission along the second transmission line; and
the receiving circuit comprising receiving means for comparing amplitudes of the communication signals transmitted from the transmitting circuit along the first and second transmission lines so as to demodulate the said information characterised in that the second transmitting means receives the communication signal from the first transmitting means to generate the inverted polarity communication signal.

We further propose in accordance with a second aspect of the invention communication apparatus in which a first control circuit comprising at least a transmitting circuit and a second control circuit comprising at least a receiving circuit, are connected by common transmission line means;
the common transmission line means comprising a first and a second transmission line;
the transmitting circuit comprising first transmitting means for converting an information carrying input signal, into a communication signal for transmission along the first transmission line and second transmitting means for generating an inverted polarity communication signal for transmission along the second transmission line;
the receiving circuit comprising receiving means for comparing amplitudes of the said communication signals transmitted from the transmitting circuit along the first and second transmission lines so as to demodulate the said information carried by the input signal, characterised in that the first transmitting means is for converting a square wave information carrying input signal at the rising and falling edges thereof into a communication signal having a predetermined gradient for transmission along the first transmission line and in that the second transmitting means receives the communication signal from the first transmitting means to generate the inverted polarity communications signal.

Embodiments of the present invention will now be described by way of example with reference to the accompanying drawings in which:
Fig. 1 is a block diagram of a multiplex transmission system;
Fig. 2 is a diagram of the transmitting and receiving circuits according to a first embodiment communication apparatus;
Fig. 3 is a diagram of the transmitting circuit according to a second embodiment of communication apparatus;
Fig. 4 is a diagram of the transmitting circuit according to a third embodiment of communication apparatus;
Fig. 5 is a block diagram of another multiplex transmission system; and
Fig. 6 is a circuit structure of the prior work presented by the inventors of the present invention.

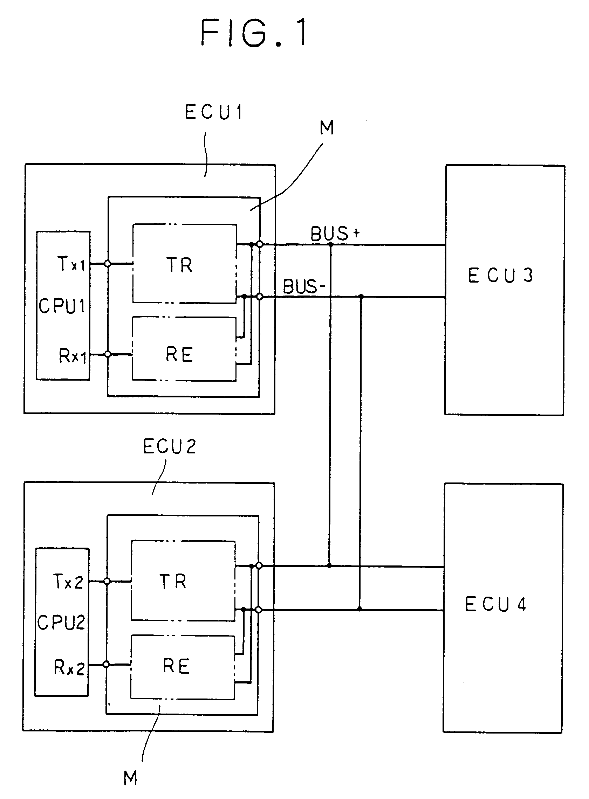

Fig. 1 is a block diagram of a multiplex transmission system as a first embodiment of the present invention. In Fig. 1, ECU1 to ECU4 are mutually connected by two transmission lines BUS+ and BUS- of the parallel pair wires and each ECU comprises a CPU and a common transmitting and receiving circuit, M section. Tx means a CPU transmitting section; Rx, a CPU receiving section; TR, a transmitting circuit; RE, a receiving circuit.

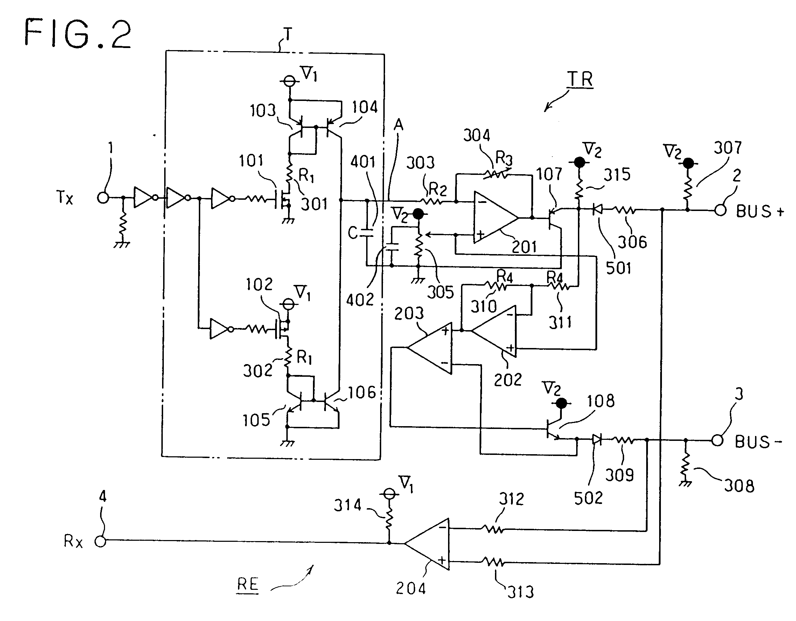

Fig. 2 shows a embodied circuit structure of the transmitting and receiving circuit M of Fig. 1. In Fig. 2, the reference numeral 1 denotes an input terminal for inputting a square wave signal sent from the transmitting section Tx of CPU; 2, an output terminal for outputting an output signal shaped to a trapezoidal wave from the square wave signal to the transmission line BUS+; 3, an output terminal for outputting an output signal polarity inverted from the trapezoidal wave signal output from the output terminal 2 to the transmission line BUS-; 4, a receiving output terminal for inputting the signal demodulated to the square wave signal from the trapezoidal wave signal inputted from the transmission lines BUS+ and BUS- to the receiving section Rx of CPU. T means a trapezoidal wave shaping circuit for shaping the square wave signal sent from the transmitting section Tx into the trapezoidal wave.

101, 102 denote FETs for driving current Miller circuit; 103 to 106, transistors forming a current Miller circuit; 107, 108, transistors for driving transmission lines; 201, an operational amplifier for adjusting BUS+ output signal level; 202, an operational amplifier for polarity inversion; 203, an operational amplifier for feedback of signal; 204, a comparator as a receiver.

301, 302 denote resistors for determining a current of a current Miller circuit having a resistance value R1; 301, 302, resistors for adjusting BUS+ output signal amplitude level having resistance values R2, R3; 305, a resistor for adjusting BUS+ output signal DC offset level; 306, 309, resistors for protecting a transistor for driving transmission lines; 307, 308, resistors for biasing the transmission lines BUS+ and BUS-; 310, 311, resistors for inverting the BUS+ signal having a resistance value R4; 312, 313, resistors for protecting a receiver; 314, a resistor for pulling up comparator output; 315, a resistor for deciding the BUS+ signal level.

401s denote a capacitor for setting transmission time of the BUS+ signal having a capacitance value C; 402, a capacitor for noise elimination.

501 denotes a diode for protecting reverse surge and disabling operation of BUS- with the signal sent to BUS+ from the other ECU; 502, a diode for protecting reverse surge.

Next, circuit operation of Fig. 2 is explained hereunder. First, in the TR section, a square wave signal conveying transmitting information from the transmitting section Tx of CPU is input to the input terminal 1. When the inputted signal is in the "H" level, the signal to be applied to the gate of FET 101 becomes "L" level and FET 101 turns OFF because it is an N-channel type transistor. Therefore, a transistor 103 and a transistor 104 which forms a current Miller circuit together with the transistor 103 are turned OFF and thereby a current does not flow from the transistor 104. Meanwhile, FET 102 is turned ON and a constant current determined by V1/R1 flows into a transistor 105 by means of the resistor 302. The similar constant current also flows into a collector of a transistor 106 forming a current Miller circuit together with the transistor 105. Here, if a capacitor 401 is charged, it is discharged due to a constant current flowing into the transistor 106 and the potential VA at the point A drops linearly to almost the GND potential.

On the other hand, when the signal inputted to the input terminal 1 is "L" level, FET 101 turns ON and a constant current determined by V1/R1 flows into the transistors 103, 104 forming together the current Miller circuit by means of the resistor 301. In this timing, FET 102 is turned OFF and a current does not flow into the transistors 105, 106. Here, if the capacitor 401 is not charged, it is charged and the potential VA at the point A linearly rises to almost V1. Since gidt = CV and i is expressed by V1/R1 and is constant, the rising or falling gradient V/t also becomes constant.

With operation of the trapezoidal wave shaping circuit T, the square wave signal inputted to the input terminal 1 is modulated to a trapezoidal wave signal and thereby a trapezoidal wave signal appears at the point A.

This trapezoidal wave signal is applied to a negative (-) terminal of the operational amplifier 201. On the other hand, a voltage VOS preset by the resistor 305 is applied to a positive (+) terminal of the operational amplifier 201. Therefore, a voltage VB to be applied to the base of the transistor 107 is expressed as follows.$\text{VB = VOS - (R3/R2)(VA - VOS)}$

As will be understood from this equation, a base potential of the transistor 107 changes with the amplitude of (R3/R2)V1 in accordance with change of potential VA at the point A with reference to the preset potential VOS and this amplitude of base potential is lowered as much as the amplitude in comparison with that when the potential VA at the point A is equal to the GND potential while VA is V1. The capacitor 402 is provided for eliminating noise. An output of this operational amplifier 201 is then inputted to the base of the transistor 107. Here, in case a base potential of the transistor 107 is lowered linearly, an emitter potential is higher as much as VBE than the base potential and is also lowered linearly following the base potential. Meanwhile, in case the base potential increases, an emitter potential is higher as much as VBE than the base potential and also increases linearly following the base potential. Thereby, a signal having the potential which is set higher as much as a voltage drop caused by the diode 501 and resistor 306 from the emitter potential is transmitted to the transmission line BUS+ from the output terminal 2.

On the other hand, an emitter potential of the transistor 107 is input to the negative (-) terminal of the operational amplifier 202 through a resistor 311. A potential VOS set by a resistor 305 is input to the positive (+) terminal of the operational amplifier 202, just like the positive (+) terminal of the operational amplifier 201. Here, since a resistance value of resistors 310, 311 is R4, an output of the operational amplifier 202 is expressed by the following equation when an emitter potential of the transistor 107 is V.$\text{VOS - (VE - VOS) = 2VOS - VE}$

This output voltage is equal to an inverted value of the emitter potential VE with reference to the setting potential VOS. An output of this operational amplifier 202 is inputted to a base of the transistor 108 through an operational amplifier 203.

Therefore, when an emitter potential VE of the transistor 107 is lowered linearly, a base potential to be applied to the transistor 108 increases linearly and an emitter potential of the transistor 108 increases linearly following increase of a base potential and is kept at a potential which is lower as much as VBE than the base potential. On the other hand, in case an emitter potential VE of the transistor 107 increases linearly, a base potential to be applied to the base of the transistor 108 lowers linearly, and an emitter potential of the transistor 108 is lower as much as VBE than the base potential and lowers linearly following the base potential. The operational amplifier 203 structures a voltage follower and controls the base potential of the transistor 108 with an output potential of the operational amplifier 202 so that the inverted emitter potential of the transistor 107 becomes equal to the emitter potential of the transistor 108.

Accordingly, a signal having a potential which is lowered as much as a voltage drop caused by a diode 502 and a resistor 309 from the emitter potential of the transistor 108 is transmitted to the transmission line BUS- from the output terminal 3. Therefore, as will be obvious from the operations explained above, communication signals to be transmitted to the transmission lines BUS+ and BUS- respectively become similar to the polarity inverted signal waveforms having the equal amplitude with reference to the preset voltage VOS.

In addition, in the RE section, the positive (+) terminal of a comparator 204 is connected to the transmission line BUS+ through a protection resistor 313, while the negative (-) terminal thereof to the transmission line BUS- through a protection resistor 312. Therefore, the comparator 204 defines "H" level as a result of comparison when a signal potential applied to the positive (+) terminal is higher than a signal potential applied to the negative (-) potential or "L" level when relationship of signal potential is reversed and outputs such signal levels from the receiving output terminal 4.

Above operations will then be explained considering an example where data is transmitted from ECU 1 to ECU 2 or received from ECU 2 to ECU 1. First, a square wave signal is transmitted from Tx 1 of CPU 1, then modulated to a trapezoidal waveform by the TR section of the transmitting and receiving circuit M within ECU 1 and is transmitted to the transmission line BUS+. Moreover, an inverted signal is then shaped from the signal waveform modulated to the trapezoidal waveform and is transmitted to another transmission line BUS-. Each output data is then inputted to ECU 2, it is demodulated to the square wave signal through comparison and decision in the RE section of the M section within ECU 2, then input to Rx 2 of CPU 2 and is then received by CPU 2.

In the same way, each ECU is capable, in Fig. 1, of executing mutual transmission or reception in accordance with the protocol (transmission regulation).

Therefore, as shown in Fig. 2, only one trapezoidal waveform shaping circuit is provided in the first embodiment explained above and a voltage feedback output to form an output trapezoidal waveform to be transmitted to the other transmission line from an output trapezoidal waveform, namely from an output waveform to the one transmission line is carried out. Accordingly, an output waveform in the inverted output side can be set to extremely accurate polarity inverted waveform of the one output waveform. As a result, generation of harmonics noise radiation due to phase shift and time delay during waveform transition can be cancelled by the signal waveforms to be transmitted to the two-wire system transmission lines BUS+ and BUS-.

Moreover, since the emitter potentials of the transistors 107, 108 are respectively inputted to the terminals of the operational amplifier 203 forming the emitter follower circuit, even when there is a difference in the base-emitter voltage VBE of the transistors 107, 108, an accurate polarity inverted waveforms can be output without any influence of such voltage difference.

Moreover, a diode 501 is inserted between the transmission line BUS+ and the transistor 107 so that an inverted signal is formed from the signal transmitted to the transmission line BUS+ from the other ECU, disabling operation of the other transmission line BUS-. The diode 501 also operates to protect the circuit from reverse surge voltage.

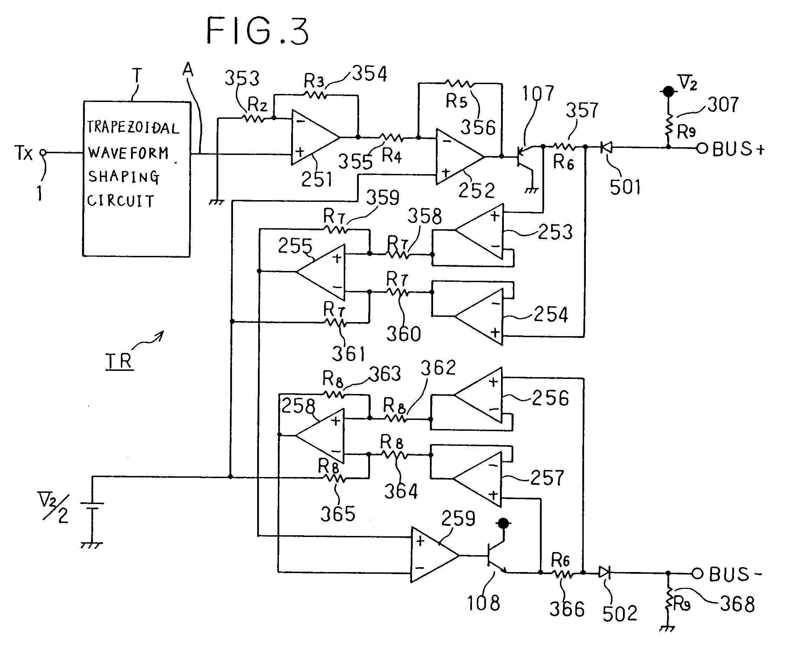

Next, a second embodiment shown in Fig. 3 will be explained. As shown in Fig. 2, the aforementioned first embodiment shapes the signal waveform polarity inverted through voltage feedback by the operational amplifier 203, while the second embodiment realizes current feedback. In this second embodiment, since the receiving circuit (RE) is identical to the circuit shown in Fig. 2, only the transmitting circuit (TR) of M section is indicated in Fig. 3.

In Fig. 3, the same or equivalent elements as those in Fig. 2 are defined by the same reference numerals. In this Fig. 3, the reference numeral 251 denotes an operational amplifier for amplifying BUS+ output signal voltage level (amplitude); 252, an operational amplifier for adjusting BUS+ output signal level; 253, 254, 256, 257, operational amplifiers for voltage follower; 255, an operational amplifier for differentially amplifying a voltage across a BUS+ monitor resistor 357; 258, an operational amplifier for differentially amplifying a voltage across a BUS- monitor resistor 357; 259, an operational amplifier for feedback.

353, 354 denote resistors for amplifying BUS+ output signal voltage level (amplitude) having resistance values R2, R3; 355, 356, resistors for adjusting BUS+ output signal level having resistance values R4, R5; 357, a resistor for BUS+ output current monitor having a resistance value R6; 358 to 361, resistors for differentially amplifying a voltage across the resistor 357 having the equal resistance value R7; 362 to 365, resistors for differentially amplifying a voltage across the resistor 366 having the equal resistance value R8; 366, a resistor for BUS- output current monitor having a resistance value R6; 367, 368, resistors for BUS- bias having the equal resistance value R9.

Next, operations of the second embodiment shown in Fig. 3 will be explained. First, the square wave signal inputted to the input terminal 1 is modulated to a corresponding trapezoidal wave signal by the trapezoidal waveform shaping circuit T just like the first embodiment and a trapezoidal wave signal appears at the point A. Therefore, a trapezoidal wave signal having the amplitude of almost V1 is inputted to the positive (+) terminal of the operational amplifier 251. The operational amplifier 251 operates on a voltage V2 ( > V1), a trapezoidal wave signal with amplitude of about V2 is outputted to the output terminal of the operational amplifier 251 and is then inputted to the negative (-) terminal of the operational amplifier 252 through the resistor 355 by setting the resistors 353, 354 so that the relation R3 = (V2/V1 - 1)R2 is obtained. Moreover, a potential V2/2 is applied to the positive (+) terminal of the operational amplifier 252. Accordingly, a voltage to be applied to the base of the transistor 157, namely a base potential of the transistor 107 changes in the amplitude (R5/R4)V2 in accordance with change of the potential VA appearing at the point A around a potential V2/2 to be applied to the positive (+) terminal and therefore a voltage which is higher as much as VBE than the base potential appears at the emitter of the transistor 107.

Here, the BUS+ bias resistor 307 has a resistance value R9 but the other ECU also has a similar resistance value. Therefore, when total of N units of ECU is connected, a combined resistance value becomes equal to R9/N. Accordingly, when an emitter voltage appearing at the emitter of the transistor 107 is VE, a current IE expressed by (V2 - VE - Vf)/(R6 + R9/N) = IE flows into the resistor 357 and a voltage difference of R6 IE is generated across the resistor 357. Where Vf is a forward voltage of the diode 551. Therefore, a voltage signal level VBUS+ of BUS+ is expressed as$\text{VBUS+ = VE + R6 IE + Vf.}$

Thereby, a trapezoidal wave signal which is higher as much as a voltage drop by the diode 501 and resistor 357 from the emitter potential of the transistor 107 is transmitted to the transmission line BUS+ from the output terminal 2.

In addition, the operational amplifiers 253, 254 form a voltage follower so that a current which is equal to a drive current of the transistor 157 flows into the monitor resistor 357. Therefore, in Fig. 3, the right side potential of the resistors 358, 360 becomes equal to VE, VE + IE R6, respectively.

Therefore, a potential to be applied to the negative (-) terminal of the operational amplifier 255 becomes equal to the potential obtained by dividing the potential V2/2 and VE + IE R6 with the resistors 360, 361, namely to the potential of (VE + IER6 + V2/2)/2 and the positive (+) terminal also has the equal potential. Accordingly, since the resistors 358 and 359 have the equal resistance value R7, an output potential of the operational amplifier 255 is indicated as$\text{2{(VE + IER6 + V2/2)/2} - VE = IER6 + V2/2.}$

This output potential becomes an input of the positive (+) terminal of the operational amplifier 259. Meanwhile, when a current flowing to the monitor resistor 366 is defined as IE′ and a number of ECUs to be connected is set to N, an emitter potential VE′ of the transistor 108 is expressed as follows. VE′ = IE′ (R6 + R9/N) + Vf Therefore, an anode potential of the diode 502 is expressed by VE′ - IE′ R6 and it is applied to the positive (+) terminal of the operational amplifier 256. Moreover, a potential VE′ is applied to the positive (+) terminal of the operational amplifier 257.

Here, these operational amplifiers 256, 257 receive a voltage across the monitor resistor 366 with each voltage follower circuit so that a current which is equal to the drive current of the transistor 108 flows to the monitor resistor 366 just like the BUS+ side. For this reason, an output voltage of the monitor resistor 366 becomes equal to VE′ - IE′ R6 and an output potential of the operational amplifier 257 becomes equal to VE′.

Since a voltage at the negative (-) terminal of the operational amplifier 258 is divided by the resistors 364, 365, an input potential thereof becomes equal to (VE′ + V2/2)/2. Therefore, a potential at the positive (+) terminal of the operational amplifier 258 also becomes equal to (VE′ + V2/2)/2 and since the resistors 362 and 363 have a resistance value R8, an output potential becomes equal to$\text{2{(VE, + V/2)/2} - (VE′ - IE′R6) = IE′ R6 + V2/2}$

This output potential becomes an input to the negative (-) terminal of the operational amplifier 259.

Here, the operational amplifier 259 controls a base potential of the transistor 108 so that the output voltages of the operational amplifiers 255 and 258 become equal. Therefore, following relationships are established.$\text{IER6 + V2/2 = IE′R6 + V2/2}$$\text{IE = IE′}$

Thereby, the drive currents of transistors 107, 108 for driving two transmission lines BUS+, BUS- become equal with each other.

Here, since the currents flowing into the transmission lines BUS+ and BUS- are reversed with each other in the flowing direction, a signal voltage level which is transmitted from the output terminal 3 and flows into the transmission line BUS- is set to the extremely accurate polarity inverted waveform of the output waveform of the other BUS+ since IE = IE′ and thereby generation of harmonics noise radiation can be cancelled as in the case of the first embodiment.

The second embodiment utilizing current feed back method is capable of eliminating an influence of fluctuation, for example, GND fluctuation of the signal level, particularly of signal level of BUS- in the grounding side and therefore this embodiment is especially suitable as the apparatus to be mounted on a vehicle wherein GND level easily changes due to driving by an actuator.

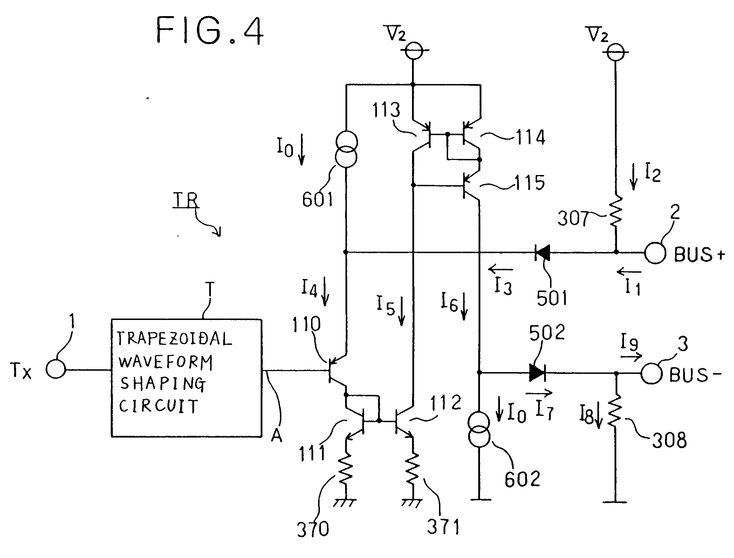

Next, a third embodiment shown in Fig. 4 will be explained. This third embodiment is also of the current feed back type, like the second embodiment explained above, wherein the direction of the currents flowing into the transmission lines BUS+, BUS- is reversed. Since the receiving circuit of this third embodiment is identical to that shown in Fig. 2, only the transmitting circuit (TR) of M section is indicated in Fig. 4.

In Fig. 4, the same or equivalent elements as those shown in Fig. 2 and Fig. 3 are defined by the same reference numerals. In Fig. 4, the reference numeral 110 denotes a transistor for driving transmission lines; 111 to 115, transistors to form a current Miller circuit; 601, 602, constant current circuits for improving the response characteristic of the circuit; 370, 371, compensation resistors of a current Miller circuit.

Operations of the structure explained above will be explained hereunder. First, the square wave signal inputted to the input terminal 1 is modulated to a corresponding trapezoidal wave signal, like the case of the first embodiment, by the trapezoidal waveform shaping circuit T and this trapezoidal wave signal appears at the point A. This trapezoidal wave signal is then applied to the base of the transistor 110. Here, in case a base potential of the transistor 110 is lowered linearly, an emitter potential is higher as much as VBE than the base potential and is also lowered following the base potential. Meanwhile, in case the base potential increases, it is higher as much as VBE than the base potential and linearly increases following the emitter potential. Thereby, a signal which is higher as much as a voltage drop by the diode 501 than this emitter potential is transmitted to the transmission line BUS+ from the output terminal 2.

A current which is almost equal to a collector current of the transistor 110 flows as a collector current of the transistor 115 by means of a current Miller circuit comprising the transistors 111, 112 and resistors 370, 371 and a current Miller circuit comprising the transistors 113 to 115. Here, constant currents generated by the constant current circuits 601, 602 are set equal to each other and resistance values of resistors 370, 371 are also set equal to each other. In addition, like the second embodiment explained above, it is assumed that the other ECUs have resistance value which is equal to the BUS+ bias resistance 307 and total of N units of ECU are connected. Under this setting, when a constant current of the constant current circuits 601, 602 is defined as I0, a signal current of BUS+ as I1, a current flowing into the resistor 307 as I2, a current flowing into the diode 501 as I3, an emitter current of the transistor 110 as I4, a collector current of the transistor 112 as I5, a collector current of the transistor 115 as I6, a current flowing into the diode 502 as I7, a current flowing into the resistor 308 as I8 and a signal current of BUS- as I9, following relationships are obtained.$\text{I1 + I2 = I3, I0 + I3 = I4, I4 ≒ I5 ≒ I6,} \text{I6 = I0 + I7, I7 = I9 + I8, I1 = (N - 1) x I2,} \text{I9 = (N - 1) x I8}$

By solving these relationships, I1 ≒ I9. Namely, a current transmitted to the transmission line BUS- can be generated from a collector current of the transistor 111 through a couple of current Miller circuits. Therefore, a current flowing into the BUS- can be set equal to the current flowing to the BUS+ as in the case of the second embodiment.

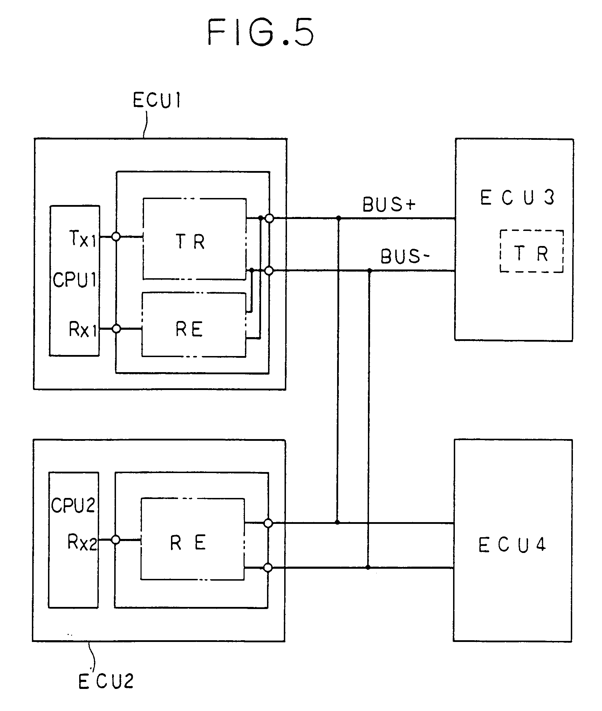

As a multiplex transmission system in the above embodiments, a system forming a transmitting circuit and a receiving circuit in each ECU for mutual transmission and reception between these circuits is presented as shown in Fig. 1. However, it is also possible, as shown in Fig. 5, ECU 1 comprises a transmitting circuit and a receiving circuit as the center station and the other ECUs 2 to 4 comprises only one of the receiving circuit and the transmitting circuit as the peripheral stations. Moreover, any type of transmission system may be employed as long as it is the balanced two-wire system. For example, a twisted-pair system can also be employed as well as the parallel pair-wire as indicated in the embodiments explained above. Moreover, in any embodiment explained above, a square wave signal is modulated into a trapezoidal wave signal by a trapezoidal waveform shaping circuit T, but it is also allowed to apply the present invention to a system where a square wave signal is transmitted without being modulated into a trapezoidal wave signal.

## Claims

1. Communication apparatus in which a first control circuit comprising at least a transmitting circuit (TR) and a second control circuit comprising at least a receiving circuit (RE) are connected by common transmission line means,
the common transmission line means comprising a first and a second transmission line (BUS+,BUS-);
the transmitting circuit (TR) comprising first transmitting means for converting information to be communicated into a communication signal for transmission along the first transmission line (BUS+) and second transmitting means for generating an inverted polarity communication signal for transmission along the second transmission line (BUS-); and
the receiving circuit (RE) comprising receiving means for comparing amplitudes of the communication signals transmitted from the transmitting circuit along the first and second transmission lines (BUS+,BUS-) so as to demodulate the said information, characterised in that the second transmitting means is arranged to receive the communication signal from the first transmitting means to generate the inverted polarity communication signal.

2. Communication apparatus as claimed in claim 1, wherein the second transmitting means is arranged to generate the inverted polarity communication signal by voltage feedback or current feedback with the signal of the first transmission line.

3. Communication apparatus in which a first control circuit comprising at least a transmitting circuit (TR) and a second control circuit comprising at least a receiving circuit (RE), are connected by common transmission line means (BUS+,BUS-);
the common transmission line means comprising a first and a second transmission line (BUS+,BUS-);
the transmitting circuit (TR) comprising first transmitting means for converting an information carrying input signal, into a communication signal for transmission along the first transmission line (BUS+) and second transmitting means for generating an inverted polarity communication signal for transmission along the second transmission line (BUS-);
the receiving circuit (RE) comprising receiving means for comparing amplitudes of the said communication signals transmitted from the transmitting circuit along the first and second transmission lines (BUS+,BUS-) so as to demodulate the said information carried by the input signal, characterised in that the first transmitting means is for converting a square wave information carrying input signal at the rising and falling edges thereof into a communication signal having a predetermined gradient for transmission along the first transmission line (BUS+) and in that the second transmitting means is arranged to receive the communication signal from the first transmitting means to generate the inverted polarity communications signal.

4. Communication apparatus according to claim 1, 2 or 3, wherein the second transmitting means comprises means (202) for inputting a communication signal voltage transmitted from the first transmission line (BUS+) to generate the inverted polarity signal.

5. Communication apparatus according to claim 1, 2 or 3, wherein the second transmitting means comprises current control means for controlling a current so that a current flowing into the first transmission line (BUS+) with transmission of the communication signal into the first transmission line (BUS+) and a current flowing into the second transmission line (BUS-) with transmission of the inverted polarity signal into the second transmission line (BUS-) become equal in amplitude but are reversed in direction each other to the signal transmitting direction toward the first and second transmission lines (BUS+,BUS-).

6. Communication apparatus according to claim 5, wherein the current control means comprises first current detecting means for detecting a current flowing into the first transmission line (BUS+), second current detecting means for detecting a current flowing into the second transmission line (BUS-) and control means (107,108;601,602) for controlling a current flowing into the second transmission line (BUS-) so that the currents detected by the first and second current detecting means are equal in amplitude but are reversed in direction to each other in relation to the signal transmitting direction in the first and second transmission line (BUS+,BUS-).

7. Communication apparatus according to claim 5, wherein the current detecting means comprises control means for extracting a current flowing into the first transmission line (BUS+) through a current Miller circuit (111-115) and controlling currents flowing into the second transmission line, based on the extracted current, so that these currents become equal in amplitude but are reversed in direction to each other in relation to the signal transmitting direction in the first and second transmission lines (BUS+, BUS-).

8. Communication apparatus according to claim 1, 2 or 3, wherein the first transmitting means comprises one-way signal enabling means for enabling transmission of the converted signal to the first transmission line (BUS+) in order to prevent the second transmitting means from operating in error with input of signal from the first transmission line (BUS+).

9. Communication apparatus according to claim 1, 2 or 3, wherein the first and second control circuits comprise the transmitting means and receiving means for mutual transmission and reception of signals.

10. Communication apparatus according to claim 1, 2 or 3, wherein the first control circuit comprises transmitting means and receiving means, the second control circuit comprising only a receiving circuit (RE) to receive a communication signal from the first control circuit, the apparatus further comprising a third control circuit having means for transmitting the communication signal to the first control circuit.

## Patentansprüche

1. Übertragungsvorrichtung, in welcher eine erste Steuerschaltung, die mindestens eine Sendeschaltung (TR) aufweist, und eine zweite Steuerschaltung, die mindestens eine Empfangsschaltung (RE) aufweist, mittels einer gemeinsamen Übertragungsleitungseinrichtung verbunden sind,
wobei die gemeinsame Übertragungsleitungseinrichtung eine erste und eine zweite Übertragungsleitung (BUS+,BUS-) aufweist;
wobei die Sendeschaltung (TR) eine erste Sendeeinrichtung, die die zu übertragende Information in ein Übertragungssignal zur Übertragung entlang der ersten Übertragungsleitung (BUS+) umwandelt, und eine zweite Sendeeinrichtung aufweist, die ein Übertragungssignal umgekehrter Polarität zur Übertragung entlang der zweiten Übertragungsleitung (BUS-) erzeugt; und
wobei die Empfangsschaltung (RE) eine Empfangseinrichtung aufweist, die die Amplituden der Übertragungssignale, die aus der Sendeschaltung entlang der ersten und zweiten Übertragungsleitungen (BUS+,BUS-) gesendet werden, vergleicht, um die Information zu demodulieren, dadurch gekennzeichnet, daß die zweite Sendeeinrichtung in der Lage ist, das Übertragungssignal aus der ersten Sendeeinrichtung zu empfangen, um das Übertragungssignal umgekehrter Polarität zu erzeugen.

2. Übertragungsvorrichtung nach Anspruch 1, bei der die zweite Sendeeinrichtung in der Lage ist, das Übertragungssignal umgekehrter Polarität mittels einer Spannungsrückkopplung oder einer Stromrückkopplung des Signals der ersten Übertragungsleitung zu erzeugen.

3. Übertragungsvorrichtung, in welcher eine erste Steuerschaltung, die mindestens eine Sendeschaltung (TR) aufweist, und eine zweite Steuerschaltung, die mindestens eine Empfangsschaltung (RE) aufweist, mittels einer gemeinsamen Übertragungsleitungseinrichtung (BUS+,BUS-) verbunden sind;
wobei die gemeinsame Übertragungsleitungseinrichtung eine erste und eine zweite Übertragungsleitung (BUS+,BUS-) aufweist;
wobei die Sendeschaltung (TR) eine erste Sendeeinrichtung, die ein eine Information tragendes Eingangssignal in ein Übertragungssignal zur Übertragung entlang der ersten Übertragungsleitung (BUS+) umwandelt, und eine zweite Sendeeinrichtung aufweist, die ein Übertragungssignal umgekehrter Polarität zur Übertragung entlang der zweiten Übertragungsleitung (BUS-) erzeugt;
wobei die Empfangsschaltung (RE) eine Empfangseinrichtung aufweist, die die Amplituden der Übertragungssignale, die aus der Sendeschaltung entlang der ersten und zweiten Übertragungsleitungen (BUS+,BUS-) gesendet werden, vergleicht, um die Information, die von dem Eingangssignal getragen wird, zu demodulieren, dadurch gekennzeichnet, daß die erste Sendeeinrichtung dazu dient, ein eine Information tragendes Rechteckwellen-Eingangssignal an seinen Anstiegsund Abfallflanken in ein Übertragungssignal, das eine vorbestimmte Steigung aufweist, zur Übertragung entlang der ersten Übertragungsleitung (BUS+) umzuwandeln, und dadurch, daß die zweite Sendeeinrichtung in der Lage ist, das Übertragungssignal aus der ersten Sendeeinrichtung zu empfangen, um das Übertragungssignal umgekehrter Polarität zu erzeugen.

4. Übertragungsvorrichtung nach Anspruch 1, 2 oder 3, bei der die zweite Sendeeinrichtung eine Einrichtung (202) aufweist, die eine aus der ersten Übertragungsleitung (BUS+) gesendete Übertragungssignalspannung eingibt, um das Signal umgekehrter Polarität zu erzeugen.

5. Übertragungsvorrichtung nach Anspruch 1, 2 oder 3, bei der die zweite Übertragungseinrichtung eine Stromsteuereinrichtung aufweist, die einen Strom so steuert, daß ein Strom, der bei einem Senden des Übertragungssignals in der ersten Übertragungsleitung (BUS+) in der ersten Übertragungsleitung (BUS+) fließt und ein Strom, der bei einem Senden des Signals umgekehrter Polarität in der zweiten Übertragungsleitung (BUS-) in der zweiten Übertragungsleitung (BUS-) fließt, amplitudengleich werden, aber in ihrer Richtung zueinander zu der Signalsenderichtung entlang der ersten und zweiten Übertragungsleitungen (BUS+,BUS-) umgekehrt werden.

6. Übertragungsvorrichtung nach Anspruch 5, bei der die Stromsteuereinrichtung eine erste Strom-Erfassungseinrichtung, die einen Strom, der in der ersten Übertragungsleitung (BUS+) fließt, erfaßt, eine zweite Strom-Erfassungseinrichtung, die einen Strom, der in der zweiten Übertragungsleitung (BUS-) fließt, erfaßt und eine Steuereinrichtung (107,108;601,602) aufweist, die einen Strom, der in der zweiten Übertragungsleitung (BUS-) fließt, so steuert, daß die Ströme, die von der ersten und der zweiten Strom-Erfassungseinrichtung erfaßt werden, amplitudengleich sind, aber in der Richtung zueinander in Bezug auf die Signalsenderichtung in der ersten und zweiten Übertragungsleitung (BUS+,BUS-) umgekehrt sind.

7. Übertragungsvorrichtung nach Anspruch 5, bei der die Strom-Erfassungseinrichtung eine Steuereinrichtung aufweist, die einen Strom, der in der ersten Übertragungsleitung (BUS+) fließt, durch eine Strom-Miller-Schaltung (111-115) gewinnt und Ströme, die in der zweiten Übertragungsleitung fließen, auf der Grundlage des gewonnenen Stroms steuert, so daß diese Ströme amplitudengleich, aber in der Richtung zueinander in Bezug auf die Signalsenderichtung in den ersten und zweiten Übertragungsleitungen (BUS+, BUS-) umgekehrt sind.

8. Übertragungsvorrichtung nach Anspruch 1, 2 oder 3, bei der die erste Sendeeinrichtung eine Einweg-Signalfreigabeeinrichtung aufweist, die ein Senden des umgewandelten Signals auf der ersten Übertragungsleitung (BUS+) freigibt, um die zweite Übertragungseinrichtung vom fehlerhaften Betrieb beim Eingang eines Signals aus der ersten Übertragungsleitung (BUS+) abzuhalten.

9. Übertragungsvorrichtung nach Anspruch 1, 2 oder 3, bei der die ersten und zweiten Steuerschaltungen die Sendeeinrichtung und Empfangseinrichtung zum gegenseitigen Senden und Empfangen von Signalen aufweisen.

10. Übertragungsvorrichtung nach Anspruch 1, 2, oder 3, bei der die erste Steuerschaltung eine Sendeeinrichtung und eine Empfangseinrichtung aufweist, die zweite Steuerschaltung lediglich eine Empfangsschaltung (RE) aufweist, um ein Übertragungssignal aus der ersten Steuerschaltung zu empfangen, wobei die Vorrichtung des weiteren eine dritte Steuerschaltung aufweist, die eine Einrichtung aufweist, die das Übertragungssignal zu der ersten Steuerschaltung sendet.

## Revendications

1. Appareil de communication dans lequel un premier circuit de commande comprenant au moins un circuit de transmission (TR) et un second circuit de commande comprenant au moins un circuit de réception (RE) sont reliés à l'aide d'un moyen de ligne de transmission commune,
le moyen de ligne de transmission commune comprenant une première et un seconde lignes de transmission (BUS+, BUS-),
le circuit de transmission (TR) comprenant un premier moyen d'émission pour convertir les informations à communiquer en un signal de communication pour une émission sur la première ligne de transmission (BUS+) et un second moyen d'émission pour générer un signal de communication de polarité inverse destiné à une émission sur la seconde ligne de transmission (BUS-), et
le circuit de réception (RE) comprenant un moyen de réception destiné à comparer les amplitudes des signaux de communication émis à partir du circuit de transmission sur les première et seconde lignes de transmission (BUS+, BUS-) de façon à démoduler ladite information, caractérisé en ce que le second moyen d'émission est agencé pour recevoir le signal de communication à partir du premier moyen d'émission pour générer le signal de communication de polarité inverse.

2. Appareil de communication selon la revendication 1, dans lequel le second moyen de transmission est agencé pour générer un signal de communication de polarité inverse par une contre-réaction en tension ou une contre-réaction en courant avec le signal de la première ligne de transmission.

3. Appareil de communication dans lequel un premier circuit de commande comprenant au moins un circuit d'émission (TR) et un second circuit de commande comprenant au moins un circuit de réception (RE) sont reliés par un moyen de ligne de transmission commune (BUS+, BUS-),
le moyen de ligne de transmission commune comprenant une première et un seconde lignes de transmission (BUS+, BUS-),
le circuit de transmission (TR) comprenant un premier moyen de transmission destiné à convertir un signal d'entrée porteur d'informations en un signal de communication pour l'émission sur la première ligne de transmission (BUS+) et un second moyen de transmission destiné à générer un signal de communication de polarité inverse pour l'émission sur la seconde ligne de transmission (BUS-),
le circuit de réception (RE) comprenant un moyen de réception destiné à comparer l'amplitude desdits signaux de communication transmis à partir du circuit de transmission sur les première et seconde lignes de transmission (BUS+, BUS-) de façon à démoduler lesdites informations portées par le signal d'entrée, caractérisé en ce que le premier moyen d'émission est destiné à convertir un signal d'entrée porteur d'informations d'onde carrée, aux fronts montant et descendant de celui-ci, en un signal de communication présentant un gradient prédéterminé pour l'émission sur la première ligne de transmission (BUS+) et en ce que le second moyen d'émission est agencé pour recevoir le signal de communication à partir du premier moyen d'émission pour générer le signal de communication de polarité inverse.

4. Appareil de communication selon les revendications 1, 2 ou 3, dans lequel le second moyen d'émission comprend un moyen (202) destiné à entrer une tension de signal de communication émis à partir de la première ligne de transmission (BUS+) pour générer le signal de polarité inverse.

5. Appareil de communication selon les revendications 1, 2 ou 3, dans lequel le second moyen d'émission comprend un moyen de commande en courant pour contrôler un courant de façon à ce qu'un courant circulant dans la première ligne de transmission (BUS+) avec l'émission du signal de communication dans la première ligne de transmission (BUS+) et un courant circulant dans la seconde ligne de transmission (BUS-) avec l'émission du signal de polarité inverse dans la seconde ligne de transmission (BUS-), deviennent égaux en amplitude mais sont de sens opposé l'un l'autre par rapport sens d'émission de signal vers les première et seconde lignes de transmission (BUS+, BUS-).

6. Appareil de communication selon la revendication 5, dans lequel le moyen de commande de courant comprend un premier moyen de détection de courant destiné à détecter un courant circulant dans la première ligne de transmission (BUS+), un second moyen de détection de courant destiné à détecter un courant circulant dans la seconde ligne de transmission (BUS-) et un moyen de commande (107, 108 ; 601, 602) destiné à commander un courant circulant dans la seconde ligne de transmission (BUS-) de façon à ce que les courants détectés par les premier et second moyens de détection de courant soient égaux en amplitude mais soient de sens opposés l'un l'autre par rapport au sens d'émission de signal dans les première et seconde lignes de transmission (BUS+, BUS-).

7. Appareil de communication selon la revendication 5, dans lequel le moyen de détection de courant comporte un moyen de commande destiné à extraire un courant circulant dans la première ligne de transmission (BUS+) par l'intermédiaire d'un circuit de courant de Miller (111 à 115) et contrôlant les courants circulant dans la seconde ligne de transmission sur la base du courant extrait, de façon à ce que ces courants deviennent égaux en amplitude mais de sens inverses l'un avec l'autre par rapport au sens d'émission du signal dans les première et seconde lignes de transmission (BUS+, BUS-).

8. Appareil de communication selon les revendications 1, 2 ou 3, dans lequel le premier moyen d'émission comprend un moyen de validation de signal à sens unique de façon à valider l'émission du signal converti vers la première ligne de transmission (BUS+) en vue d'éviter au second moyen d'émission de fonctionner en état d'erreur avec l'entrée du signal provenant de la première ligne de transmission (BUS+).

9. Appareil de communication selon les revendications 1, 2 ou 3, dans lequel les premier et second circuits de commande comprennent les moyens d'émission et de réception pour une émission et une réception mutuelles de signaux.

10. Appareil de communication selon les revendications 1, 2 ou 3, dans lequel le premier circuit de commande comprend un moyen d'émission et un moyen de réception, le second circuit de commande ne comprend qu'un circuit de réception (RE) pour recevoir un signal de communication issu du premier circuit de commande, l'appareil comprenant en outre un troisième circuit de commande comportant un moyen pour transmettre le signal de communication au premier circuit de commande.
